# EUROPEAN PATENT APPLICATION

(11) **EP 2 985 315 A1**
(43) Date of publication of application: **17.02.2016**
(21) Application number: 14180918.6
(22) Date of filing: 14.08.2014
(51) Int. Cl.: C08L 65/00, C09D 165/00, C08J 5/22, H01B 1/12

(54) **Color tailoring PEDOT:PSS films with polymeric additive**

(71) Applicant: Covestro Deutschland AG, 51373 Leverkusen (DE)
(72) Inventor: Kartawidjaja, Fransiska Cecilia, 328847 Singapore (CN); Theivanayagam, Chairman Deivaraj, 40489 Düsseldorf (DE); Schmidt, Axel, 40933 Köln (DE); Singh, Nisha Hari, Singapore 510231 (CN)
(74) Representative: Levpat

(57) **Abstract**

The present invention provides an aqueous composition, comprising (a) a conducting polymer selected from the group consisting of polyanilines, polypyroles, polythiophenes and polyphenylenes, (b) a polyacid and (c) a polymeric additive having hydroxyl functional groups, wherein the pH-value of the aqueous composition is ≤ 3.5. Advantageously, the composition can be transformed into transparent conductive films.

## Description

The present inventions concerns a composition for producing organic conductive polymer films. The films are colorless and particularly useful for applications such as display and touch panel applications.

Organic electronics technology has been progressing rapidly since the invention of conducting polymer. The conducting polymers that are used for optoelectronics are typically based on polyanilines, polypyroles, polythiophenes, and polyphenylenes families (Groenendaal L.; Jonas F.; Freitag D.; Pielartzik H.; Rynolds J.R.; Adv Mater, 2000, 12, 481 - 494). Among these, poly(3,4-ethylenedioxythiophene) (PEDOT) has been championed as the most promising one due to its high conductivity (up to 1000 S/cm in commercial product via doping) and visible light transmission, flexibility, good thermal and chemical stability, and its possibility to be produced by roll-to-roll which enables cost-effective production as compared to other semiconducting materials that requires vacuum coating deposition (Kim Y.H.; Sachse C.; Machala M. L.; may C.; Muller-Meskamp L.; Leo K. Adv Funct Mater, 2011, 21, 1076 - 1081). PEDOT by itself is insoluble in most solvents. However, it is dispersible in water by doping with poly(styrenesulfonic acid) (PSS) which acts as a counter ion for the positively charged PEDOT. The aqueous dispersion of PEDOT:PSS is deep blue in color, thus in the coated film form, it is bluish. The extent of the blue color depends on the thickness of the coated film. The thicker the film, the bluer it becomes. PEDOT:PSS film gives blue hue as it has electronic bandgap which absorb light at λₘₐₓ of ∼ 610 nm (red visible light region). This bluish appearance has been one of the limitation in using PEDOT:PSS conductive film for display application as it requires conductive film with natural transmission color without blue or yellow hue.

The benefits of having a color neutral film, in particular an organic conducting polymer film, coupled with its advantages mentioned earlier, would help in making it a better contender for replacing the widely used Indium Tin Oxide (ITO), which is brittle and has high cost production, for display and touch panel applications.

Thus, the present invention provides an aqueous composition, comprising (a) a conducting polymer selected from the group consisting of polyanilines, polypyroles, polythiophenes and polyphenylenes, (b) a polyacid and (c) a polymeric additive having hydroxyl functional groups, wherein the pH-value of the aqueous composition is ≤ 3.5.

This aqueous composition can advantageously be transformed into a film, which is not only conducting, but also at least substantially colorless. Accordingly, the film based on the composition according to the present invention may be used instead of the widely used indium tin oxide (ITO), which is brittle and expensive to produce. Thus, the present invention offers a possibility for producing conductive films, which have the above-mentioned advantageous properties and are cheaper to produce than ITO films.

The natural transmission color (or color neutrality) are typically defined by the color space a*b* values close to 0. A positive value of b* gives yellow hue, while a negative value of b* gives blue hue. Hence, "substantially colorless" in the sense of the present invention can be defined in that the color difference between the light transmitted through the film and the light source is smaller than 0.005. Color scales can be characterized according to the procedures described in AS TM E308.

It is believed that when transforming the aqueous composition according to the present invention into a film, the drying or heating process gives rise to the formation of polyene systems in the polymeric additive, which absorb in a region of the visible light complementary to the region of light absorbed by the combination of conducting polymer (a) and polyacid (b). A "polyene system" within the meaning of the present invention comprises the presence of conjugated carbon-carbon double bonds in the polymeric additive, i.e. the polymeric additive comprises polyunsaturated moieties. It was further found that when the aqueous composition exhibits a pH-value of ≤ 3.5, dehydration of the polymer additive to a polyene is catalyzed, thus requiring lower temperatures than expected.

Preferably, (a) the conducting polymer or a combination of (a) the conducting polymer and (b) the polyacid absorb light having wavelengths in the range of from 580 nm to 700 nm, such that (a) or the combination of (a) and (b) have a blue color, wherein the composition comprising (a), (b) and (c) is colorless or substantially colorless.

Advantageously, the conducting polymer (a) is a polythiophene and the polyacid (b) is a polysulfonic acid, preferably poly(3,4-ethylenedioxythiophene) and poly(styrenesulfonic acid). Poly(3,4-ethylenedioxythiophene) is known under the name PEDOT and its advantageous properties as conductive polymer are well-established. Similarly, poly(styrenesulfonic acid) is known under the name PSS; the combination is known as PEDOT:PSS. This combination is particularly suited for the composition according to the present invention. In particular, PSS can be used to tailor the pH value of the composition as needed.

Regarding the polymeric additive (c), it is mandatory that it has hydroxyl functional groups. It has been found that poly(vinyl)alcohol (PVA) is most suitable for use as polymeric additive (c) in the present invention. The molecular weight of poly(vinyl)alcohol can be used to tailor the viscosity of the composition into ranges beneficial for certain coating systems in order to achieve a uniform coating. Generally, higher molecular weight PVA gives rise to higher viscosities of the In particular, a molecular weight in the range of from ≥ 10,000 to ≤ 200,000 was found to be suitable for common and suitable coating systems, such as kiss coating. Thus, it is preferred that the polymeric additive (c) is poly(vinyl)alcohol having a molecular weight in the range of from ≥ 10,000 to ≤ 200,000.

Regarding to the amount of polymeric additive (c), in particular in the case of the preferred PVA, it was found that a concentration of at least 0.05 wt.-%, based on the total weight of the total composition, was necessary to obtain an at least substantially colorless film from the composition according to the present invention. Hence, it is preferred that the polymeric additive (c), preferably PVA, is contained in the composition according to the present invention in an amount of at least 0.05 wt.-%, based on the total weight of the total composition. It is further preferred that the polymeric additive (c) is contained in an amount in the range of from ≥ 0.1 to ≤ 10 wt.-%, preferably in the range of from ≥ 0.12 to ≤ 8 wt.-%, more preferably in the range of from ≥ 0.14 to ≤ 5 wt.-%. Keeping the amount of the polymeric additive, preferably PVA, in the preferred ranges has the effect of achieving a combination of improved color neutrality of the final film while maintaining similar sheet resistance as compared to a PEDOT:PSS film not containing the polymeric additive (c).

The composition according to the present invention is easily transformed into a film. During processing of the composition into a film, wherein a certain heating is used, at least some of the hydroxyl functionalities of the polymeric additive (c) are lost and polyene structures are obtained, which gives rise to the above-mentioned properties of the film such as being substantially colorless and exhibiting similar electrical properties like an conducting film comprising only components (a) and (b), such as an PEDOT:PSS film.

Thus, the present invention further provides a film, comprising a conducting polymer (a) selected from the group consisting of polyanilines, polypyroles, polythiophenes and polyphenylenes, a polyacid (b) and a polymeric additive (c) comprising polyene structures obtained from hydroxyl functional groups.

Preferably, the conducting polymer (a) is a polythiophene and the polyacid (b) is a polysulfonic acid. More preferably, the conducting polymer (a) is poly(3,4-ethylenedioxythiophene) which is known as PEDOT and the polyacid (b) is poly(styrensulfonic acid) known as PSS and the polymeric additive (c) is poly(vinyl)alcohol. With regard to the PVA, the same amounts and molecular weights apply as already discussed above.

The film according to the present invention is advantageously obtained by coating a substrate with the composition according to the present invention, followed by heating the film. As already discussed above, upon heating polyene structures are obtained from the hydroxyl group containing polymeric additive (c). Hence, another object of the present invention is a process for producing a conducting film on a substrate, the process comprising the following steps:
(i) coating a substrate with a composition according to the present invention,
(ii) heating the coating.

Substrates can be selected from known polymeric films, paper sheets and generally surfaces of articles made of polymeric material, paper or even metal. Polymeric films used as substrates are preferably flexible and transparent, since a transparent, flexible and colorless conducting film on such films are desirable in the field of display and touch panel applications. Preferably, polymeric films used as substrates in the present invention are thermoplastics such as polycarbonate (PC) and/or polymethylmethacrylates (PMMA) or coextruded PC/PMMA films. Films like this are commercially available, e.g. from Bayer Material Science (Germany) under the tradenames Makrofol® and Makrolon®, respectively. The films to be used as substrates in the present invention can be selected by the skilled person according to the desired properties such as thickness, transparency, hardness, flexibility, formability and/or heat resistance.

After coating a substrate with the composition according to the present invention in step (i), the coating is heated, thereby transforming the polymeric additive (c) having hydroxyl groups into a component having polyene structures. It was found that the temperature of the heating may have advantageous effects on the film obtained. In particular, it is preferred that the heating is conducted at a temperature in the range of from ≥ 50 °C to ≤ 200 °C, preferably in the range of from ≥ 70 °C to ≤ 170 °C, more preferably in the range of from ≥ 80 °C to ≤ 150 °C, even more preferably in the range of from ≥ 90 °C to ≤ 140 °C, and even more preferably ≥ 100 °C to ≤ 130 °C. Higher temperatures, i.e. higher temperatures as stated, are likely to give rise to films exhibiting darker colors or discoloration, which is not desired. Using lower temperatures may lead to an uncomplete drying of the film or films still exhibiting the also undesirable coloration particular with PEDOT:PSS films.

Preferably, the heating is conducted over a period of time in the range of from ≥ 2 minutes to ≤ 20 minutes, preferably in the range of from ≥ 3 minutes to ≤ 18 minutes, more preferably in the range of from ≥ 5 minutes to ≤ 16 minutes. Similar to the effects observed with the heating temperature, longer heating times may lead to undesired discoloration of the film, while lower temperature fail to achieve the desirable effects of the present invention.

Preferably, the substrate is coated in step (i) of the inventive process with a coating having a wet thickness in the range of from ≥ 5 µm to ≤ 40 µm, preferably in the range of from ≥ 10 µm to ≤ 30 µm, more preferably in the range of from ≥ 15 µm to ≤ 25 µm. Films obtained from coatings having the described thicknesses exhibit the desired combination of flexibility, conductivity, transparency and color neutrality.

Because of the excellent properties of the inventive films, the films are suitable for applications in the productions of display and touch screen application such as replacement for existing ITO film applications.

Hence, another object of the present invention is the use of the films according to the present invention for the production of transparent conductive films

### Examples

Two types of commercial PEDOT:PSS were used for the studies, Clevios FET and Clevios PH1000 (Heraeus Limited). Clevios FET is a high conductive PEDOT:PSS ready to use formulation that contains ethylene glycol, while Clevios PH1000 is a pristine PEDOT:PSS formulation without any additives. PVA of different molecular weights were obtained from Sigma Aldrich. The average molecular weights used are 13,000 - 23,000 (Product code: 363170), 31,000 - 50,000 (Product code: 363073), and 89,000 - 98,000 (Product code: 341584).

### Example 1:

Several PEDOT:PSS_PVA formulations were prepared by varying the wt.-% of PVA in the formulation. The amount of PVA added were: 0.042, 0.168, 0.42, and 0.84 wt-%.

The preparation followed the following general procedure: 24 mL of water was heated to 80 °C. 1 g of PVA was added slowly while stirring continuously. The solution was then heated at 80 °C for 4.5 h. Next, this PVA solution was filtered using a 0.2 µm filter, which yielded a solid content of approximately 3.5 to 4 wt.-%. The obtained dispersions of PEDOT:PSS with PVA were sonicated for 30 min and subsequently left overnight.

### Example 2:

Polycarbonate substrate (DE1-1; thickness 175 µm) was plasma treated using the DIENER - Nano plasma surface technology equipment for 90 seconds. Air was used as the carrier gas. An automatic film applicator was used to coat the PEDOT:PSS film with coating speed of 80 mm/s. The coated film was then thermally dried at 80 to 130 °C for 3 to 15 min. The sheet resistance of the film was measured by using a Nagy sheet resistance meter, which is based on 4-point probe measurement. The % Light transmittance (%LT), %Reflectance (%R) and %Haze of the film were characterized by Hunterlab, based on ASTM D1003. The %Absorbance (%Abs) was calculated by the following formulation: %Abs = 100% - %LT - %R. The color scales were characterized by the same equipment as described in ASTM E308. The viscosity of the formulation was measured by an Anton Paar rheometer at shear rate of 102 s⁻¹ and temperature of 25 °C. To study molecular structure of the coated film, the measurements of ATR FTIR (Perkin Elmer Spectrum 100) and XPS (ULVAC-PHI Versaprobe 5000 spectrometer) were carried out.

### Results

Table 1 and show the electrical and optical properties of Clevios FET PEDOT:PSS films (10 and 20 µm wet film thickness (WFT)) with various wt.-% of PVA, together with the control films for comparison.

**Table 1: Electrical, optical, and rheology properties of PEDOT:PSS (control) and PEDOT:PSS_PVA coated films (20 µm WFT).**

| **Wt.-% of PVA** | **Rs (Ω/□)** | **LT (%)** | **R (%)** | **Abs (%)** | **YI** | **L*** | **a*** | **b*** | **Δcolor** | **Haze (%)** | **Viscosity (cP)** |
|---|---|---|---|---|---|---|---|---|---|---|---|
| **20 µm WFT** | | | | | | | | | | | |
| 0.84% | 157.7 ± 8.2 | 79.7 | 7.9 | 12.4 | 0.05 | 91.54 | -0.32 | 0.21 | 0.0006 | 0.3 | 149 |
| 0.84%, Control | 113.2 ± 7.1 | 82.6 | 8.3 | 9.1 | -3.83 | 92.92 | -0.85 | -1.53 | 0.0045 | 0.4 | 29.7 |
| 0.42% | 124.7 ± 3.8 | 78.1 | 7.5 | 14.4 | -0.91 | 90.85 | -0.73 | -0.08 | 0.0012 | 0.3 | 135 |
| 0.42%, Control | 102.1 ± 7.3 | 81.8 | 7.9 | 10.3 | -3.38 | 92.57 | -1.52 | -1.00 | 0.0045 | 0.4 | 39.9 |
| 0.168% | 101.4 ± 4.9 | 77.7 | 7.5 | 14.8 | -2.75 | 90.68 | -0.71 | -1.00 | 0.0032 | 0.4 | 77.9 |
| 0.168%, Control | 93.3 ± 9.0 | 81.1 | 7.6 | 11.3 | -3.55 | 92.24 | -0.87 | -1.36 | 0.0041 | 0.4 | 49 |
| 0.042% | 88.0 ± 3.0 | 79.6 | 7.6 | 12.8 | -3.91 | 91.57 | -0.66 | -1.61 | 0.0046 | 0.5 | 79.5 |
| 0.042%, Control | 88.5 ± 3.7 | 80.9 | 7.7 | 11.4 | -3.79 | 92.13 | -0.70 | -1.55 | 0.0040 | 0.5 | 46.7 |

**Table 2: Electrical, optical, and rheology properties of PEDOT:PSS (control) and PEDOT:PSS_PVA coated films (10 µm WFT).**

| **Wt.-% of PVA** | **Rs (Ω/□)** | **LT (%)** | **R (%)** | **Abs (%)** | **YI** | **L*** | **a*** | **b*** | **Δcolor** | **Haze (%)** | **Viscosity (cP)** |
|---|---|---|---|---|---|---|---|---|---|---|---|
| **10 µm WFT** | | | | | | | | | | | |
| 0.84% | 364.4 ± 41.5 | 85.0 | 8.0 | 7.0 | 0.84 | 93.89 | -0.80 | 0.82 | 0.0019 | 0.40 | |
| 0.84%, Control | 232.1 ± 18.4 | 86.2 | 8.9 | 4.9 | -1.78 | 94.43 | -0.23 | -0.81 | 0.0026 | 0.60 | |
| 0.42% | 266.9 ± 9.8 | 84.2 | 8.0 | 7.8 | -0.29 | 93.53 | -0.99 | 0.33 | 0.0014 | 0.20 | |
| 0.42%, Control | 210.3 ± 6.8 | 86.0 | 8.7 | 5.3 | -2.47 | 94.34 | -0.59 | -0.99 | 0.0026 | 0.50 | |
| 0.168% | 223.0 ± 14.2 | 84.3 | 8.0 | 7.7 | -1.40 | 93.61 | -1.06 | -0.21 | 0.0017 | 0.50 | |
| 0.168%, Control | 191.2 ± 6.0 | 85.9 | 8.5 | 5.6 | -2.50 | 94.32 | -0.70 | -0.95 | 0.0026 | 0.40 | |
| 0.042% | 197.4 ± 8.6 | 85.0 | 8.2 | 6.8 | -2.20 | 93.93 | -0.99 | -0.65 | 0.0029 | 0.30 | |
| 0.042%, Control | 198.9 ± 6.7 | 85.6 | 8.3 | 6.1 | -2.31 | 94.17 | -0.97 | -0.72 | 0.0026 | 0.50 | |

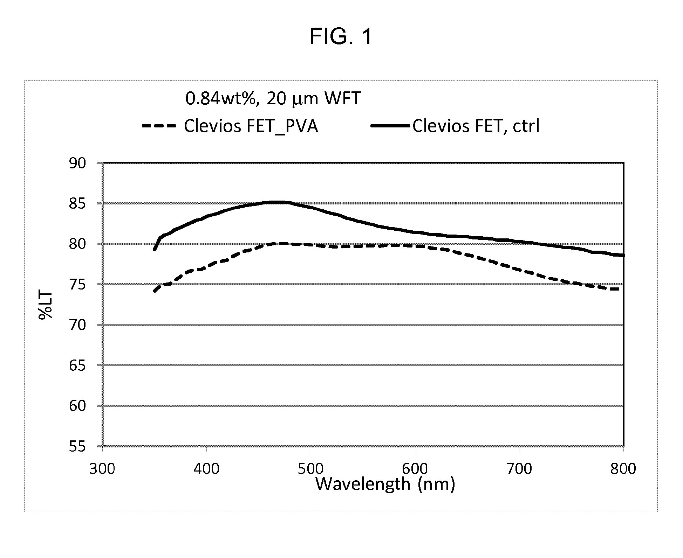

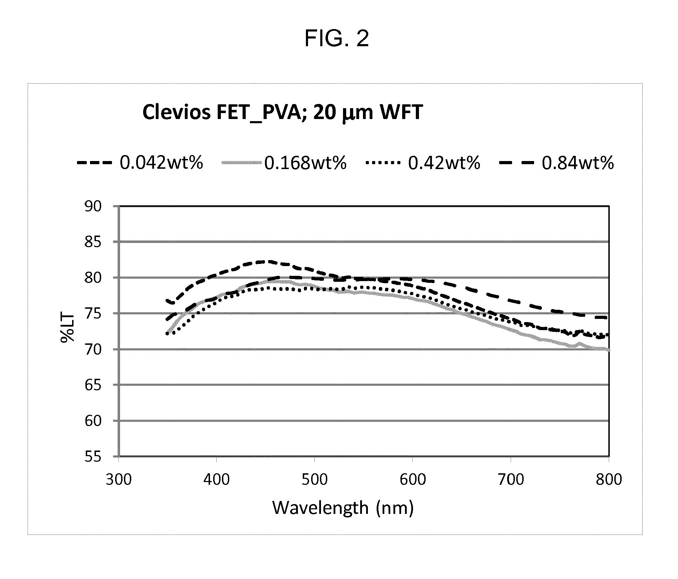

The results set forth in Tables 1 and 2, show that addition of PVA into Clevios FET formulation changed the electrical and optical properties of PEDOT:PSS, both for 10 and 20 µm WFT coated films. As the wt.-% of PVA increases, the sheet resistance of the film increases as PVA may obstruct the conductivity path of PEDOT. The %LT decreases, while %Abs increases with increasing wt.-% of PVA. While there is a higher absorption across the visible wavelength range, the higher absorption at blue-green region is more prominent as observed from the transmittance spectrum, Figure 2(a). However, it is also noted that by increasing the wt.-% of PVA to 0.84%, the %LT increases. This may due to the increase transmittance at red region with increasing amount of PVA as observed in Figure 2(b).

The film was noted to be more color neutral with Δcolor is decreasing towards 0 with increasing PVA concentration in the formulation. The b* value also becomes more positive (towards yellow hue) as the amount of PVA increases as reaffirmed by the increase in Yellow Index (YI) values. The obvious effect of PVA on the color values of PEDOT:PSS film is started to be observed from 0.168wt.-% PVA concentration onwards.

At the same time, it was also observed that PVA increases the viscosity of the Clevios FET formulation. The higher viscosity of Clevios FET_PVA may be beneficial for coating system which requires high viscosity to get uniform coating. For example, kiss coating system requires formulations with viscosities in the range of from 50 to 2000 cP.

Based on the above observations, PVA indeed can be used to tailor the color neutrality of the PEDOT:PSS film. PEDOT:PSS mixed with 0.168wt.-% of PVA was found to be the optimized formulation whereby it has better color neutrality while maintaining similar sheet resistance as compared to the PEDOT:PSS control coated film. The formulation viscosity was also found to be within the advisable viscosity range of kiss coating.

### Example 3:

The effect of molecular weights of PVA on PEDOT:PSS_PVA formulation was then studied. Table 3 shows the tabulated results of the electrical, optical, and rheology properties of the PEDOT:PSS (control) and PEDOT:PSS_PVA coated films. Three different ranges of PVA molecular weights were used for the studies, namely 13,000 to 23,000, 31,000 to 50,000, and 89,000 to 98,000. The concentration of PVA was fixed at 0.168 wt.-% in the formulation. It is observed that the sheet resistances are similar, regardless of the molecular weight of PVA used in the formulation. The %LT decreases with increasing molecular weights, accompanied by the increases in %Abs. There are no conclusive trends in the a*b*, YI, and Δcolor, however it can be said that PVA regardless of the molecular weights can be used to obtain a more color neutral PEDOT:PSS film. A more obvious effect of PVA molecular weight was observed on the rheology property of the formulation, whereby higher molecular weight PVA gives higher viscosity.

**Table 3: Electrical, optical, and rheology properties of PEDOT:PSS (control) and PEDOT:PSS_PVA coated films as function of PVA molecular weight (Mw).**

| **Wt.- % PVA** | **Mw of PVA** | **Mean Rs (Ω/□)** | **LT (%)** | **R (%)** | **Abs (%)** | **YI** | **L*** | **a*** | **b*** | **Δcolour** | **Haze (%)** | **Viscosity (cP)** |
|---|---|---|---|---|---|---|---|---|---|---|---|---|
| 0.168 | 13,000 - 23,000 | 239.5 ± 13.7 | 85.6 | 8.7 | 5.7 | -1.22 | 94.18 | -0.21 | -0.53 | 0.0015 | 0.2 | 49.7 |
| | 31,000 - 50,000 | 234.3 ± 8.9 | 84.9 | 8.3 | 6.8 | -1.87 | 93.88 | -0.79 | -0.58 | 0.0022 | 0.5 | 53.2 |
| | 89,000 - 98,000 | 246.8 ± 18.8 | 84.3 | 8.7 | 7.0 | -1.24 | 93.62 | -0.84 | -0.23 | 0.0015 | 0.3 | 82.6 |
| | control | 218.2 ± 10.7 | 85.9 | 8.8 | 5.3 | -2.32 | 94.32 | -0.46 | -0.97 | 0.0029 | 0.3 | 46 |

### Example 4: Stacking sequence studies

### 4.1 Stacking sequence studies

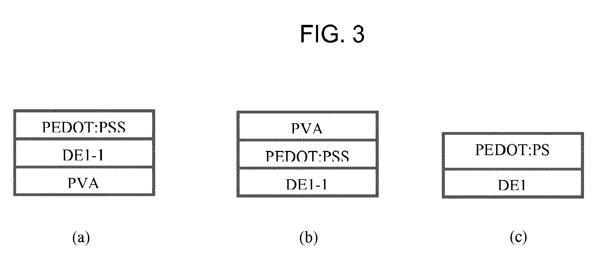

To study the influence of PVA on the color of PEDOT:PSS_PVA film, PVA and PEDOT:PSS are coated as a separate entity on the same substrate. One film is having PEDOT:PSS and PVA coated on the opposite side of the substrate (stacking structure: PEDOT:PSS / DE1-1 / PVA, Figure 3(a)) and another film is having PEDOT:PSS overcoated by PVA (stacking structure: PVA / PEDOT:PSS / DE1-1, Figure 3(b)). For a complete comparison, PEDOT:PSS and PVA mixed formulation (PEDOT:PSS_PVA) is coated on DE1-1 (Figure 3(c)).

The calculated a* and b* of the films (a*_{film}= a*_{DE1-1} + a*_{PEDOT:PSS} + a*_{PVA}; b*_{film} = b*_{DE1-1} + b*_{PEDOT:PSS} + b*_{PVA}) should be similar to the measured ones, if PVA and PEDOT:PSS has no reaction with each other. %LT should be more or less similar as well between these two different stacking structure films. The amount of PVA in the PEDOT:PSS_PVA mixture was fixed at 2 wt.- % for the studies. Both Clevios FET and Clevios PH1000, specified in each section, were used as the PEDOT:PSS film.

### 4.2 Clevios FET (2wt.-%) with PVA (2wt.-%)

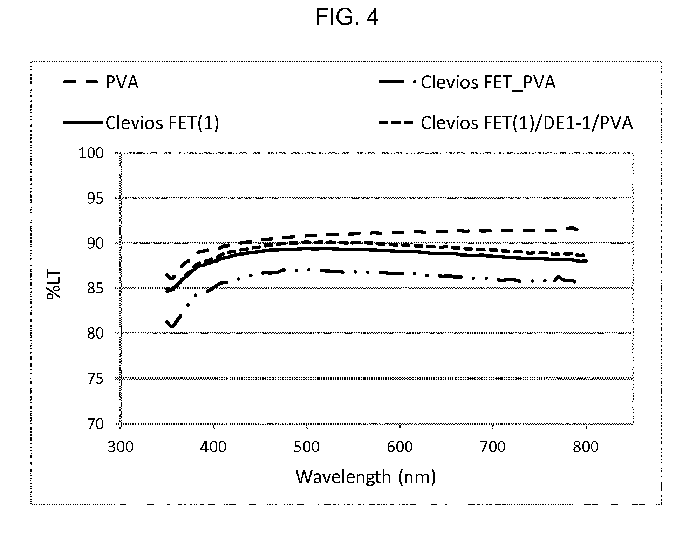

The optical and electrical properties of Clevios FET (2 wt.-%) and PVA (2 wt.-%) are summarized in Table 4. All films were dried at 130 °C for 3 min. By coating PVA alone on DE1-1, it is observed that the PVA layer increases the %LT, YI, and b* value of the film. When Clevios FET and PVA films are coated on the different sides of the substrate, the calculated a* and b* values are similar to the measured ones. The transmittance spectrum of this film is also similar to that of Clevios FET spectrum as shown in Figure 4.

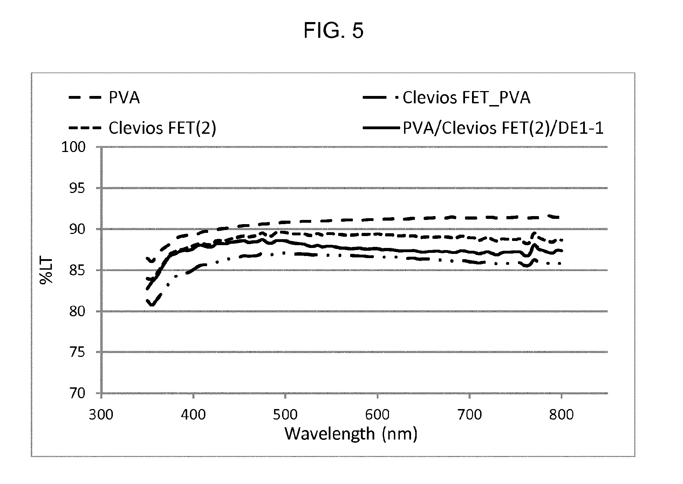

Interestingly, a big difference in the b* values between the calculated and measured ones is observed when PVA is coated on top of Clevios FET. The difference in the color b* value is accompanied by the drop in %LT and increase in %Abs. In the mixture formulation, Clevios FET_PVA coated film is also shown to have lower %LT and higher %Abs as compared to the Clevios FET film. The increase in %Abs is caused by higher absorption in the red-green visible light region, as observed from the light transmittance spectrum in Figure 5. It is then suggested that the color change observed could only happen if there is interaction between PVA and Clevios FET PEDOT:PSS. In the case of Clevios FET / DE1-1 / PVA, there is no interaction between PVA and PEDOT:PSS, thus the measured a*b* values are similar to the calculated ones. In the case of PVA / Clevios FET / DE1-1, there is interaction between PVA and PEDOT:PSS at the interfaces of the two when PVA overcoated the PEDOT:PSS film and this interaction caused the change in color and optical properties of the film. Mixing the PVA and Clevios FET together resulted in a more significant color change for the coated film.

**Table 4: Electrical and optical properties of Clevios FET(2wt.-%) and PVA (2wt.-%) with different stacking sequence.**

| **Sample** | **Rs(Ω/□)** | **LT (%)** | **R (%)** | **Abs (%)** | **Haze (%)** | **YI** | **L*** | **a*** | **b*** | **Calc .a*** | **Calc .b*** |
|---|---|---|---|---|---|---|---|---|---|---|---|
| DE1-1 | - | 90 | 9.5 | 0.5 | 0 | 0.57 | 95.99 | 0.02 | 0.29 | | |
| PVA 2wt.-% | - | 91 | 8.8 | 0.2 | 0.3 | 0.86 | 96.4 | -0.04 | 0.48 | | |
| Clevios FET (1) | 500.5 ± 22.2 | 89.3 | 8.0 | 2.7 | 0.1 | 0.03 | 95.69 | -0.25 | 0.14 | | |
| Clevios FET (1) / DE1-1 / PVA | 500.5 ± 22.2 | 90.0 | 7.3 | 2.7 | 0.1 | 0.2 | 95.98 | -0.28 | 0.25 | -0.27 | 0.33 |
| Clevios FET (2) | 493.3 ± 17.1 | 89.1 | 8.0 | 2.9 | 0.4 | 0.47 | 95.6 | -0.18 | 0.34 | | |
| PVA / Clevios FET (2) / DE1-1 | Non conductive | 86.2 | 9.3 | 4.5 | 0.6 | -0.43 | 94.39 | -0.23 | -0.11 | -0.20 | 0.53 |
| Clevios FET_PVA | 3116.4 ± 395.6 | 87.7 | 8.9 | 3.4 | 0.5 | 1.38 | 95.02 | 0.19 | 0.63 | | |

### 4.3 Clevios PH1000 (0.6wt.-%) with PVA (0.6wt.-%)

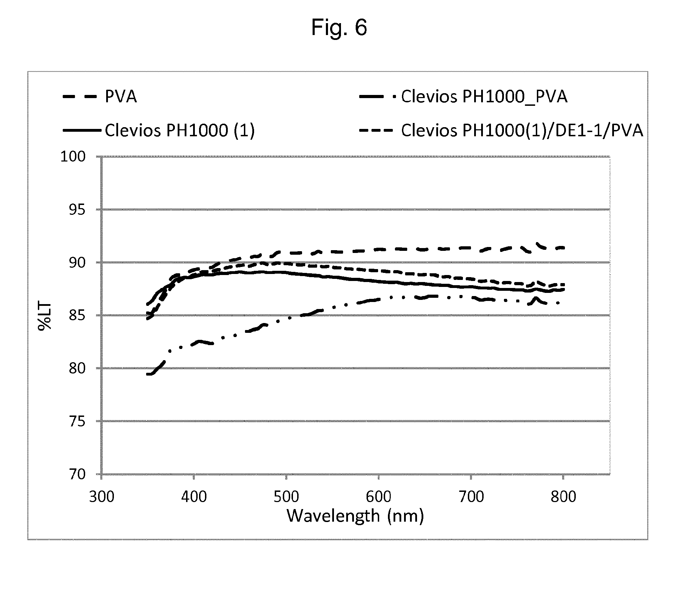

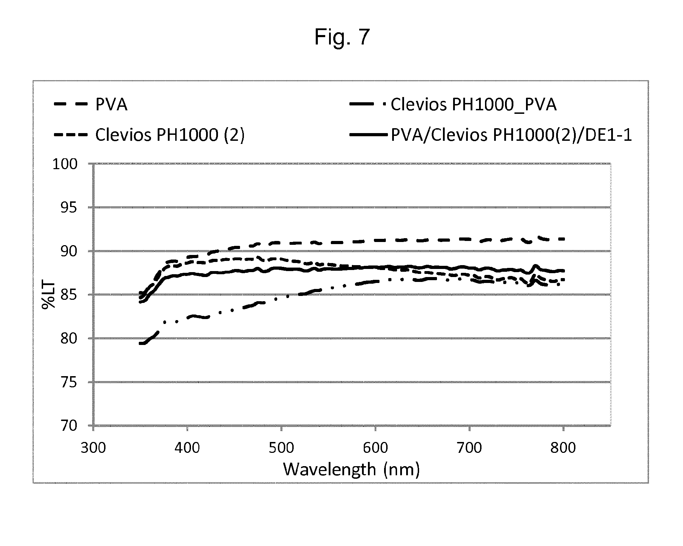

The same studies were also done for Clevios PH1000. The optical and electrical properties of the films are summarized in Table 5. The light transmittance spectra of the films are shown in Figures 6 and 7. The measured a* and b* values of Clevios PH1000 / DE1-1 / PVA are shown to be similar to the calculated a* and b* as there is no interaction between PEDOT:PSS and PVA. The light transmittance spectrum of this stacked film is also similar with Clevios PH1000 film, as shown in Figure 6. When the stacking sequence was PVA / Clevios PH1000 / DE1-1, there is a big difference in a* and b* values between the measured and calculated ones. The %Abs of this stacked film is also higher than the Clevios PH1000 film. The light transmittance spectrum (Figure 7) showed that there is higher absorption in the blue-green region which causes the increase in %Abs. These results reaffirm the suggestion that the interaction of PEDOT:PSS and PVA caused an overall change in the optical properties of the film.

**Table 5: Electrical and optical properties of Clevios PH1000 and PVA with different stacking sequence.**

| Sample | Resistance-3cm distance (kΩ) | LT (%) | R(%) | Abs (%) | Haze (%) | YI | L* | a* | b* | Calc. a* | Calc. b* |
|---|---|---|---|---|---|---|---|---|---|---|---|
| DE1-1 | - | 90 | 9.5 | 0.5 | 0 | 0.57 | 95.99 | 0.02 | 0.29 | | |
| PVA | - | 91 | 8.8 | 0.2 | 0.3 | 0.86 | 96.4 | -0.04 | 0.48 | | |
| Clevios PH1000 (1) | 2324.8 ± 226.0 | 88.5 | 8.9 | 2.6 | 0.1 | -0.82 | 95.41 | -0.27 | -0.3 | | |
| Clevios PH1000 (1) / DE1-1/PVA | 2324.8 ± 226.0 | 89.5 | 7.9 | 2.6 | 0.1 | -0.47 | 95.78 | -0.32 | -0.09 | -0.29 | -0.11 |
| Clevios PH1000 (2) | 2036.1 ± 110.0 | 88.4 | 8.7 | 2.9 | 0.3 | -1.03 | 95.35 | -0.29 | -0.4 | | |
| PVA / Clevios PH1000 (2) / DE1-1 | Non conductive | 88 | 8.8 | 3.2 | 0.6 | 0.46 | 95.15 | 0.03 | 0.23 | -0.31 | -0.21 |
| Clevios PH1000_PVA | Non conductive | 85.7 | 8.2 | 6.1 | 0.3 | 3.33 | 94.14 | 0.19 | 1.66 | | |

### 4.4 Drying temperature and time studies

For this study, the films were subjected to different drying temperature and time to see their effects on the electrical and optical properties of the coated films. The temperatures chosen were 80 and 130 °C and the drying time was 3 or 15 min.

### 4.5 Clevios FET (2 wt.-%) with PVA (2.-wt.-%)

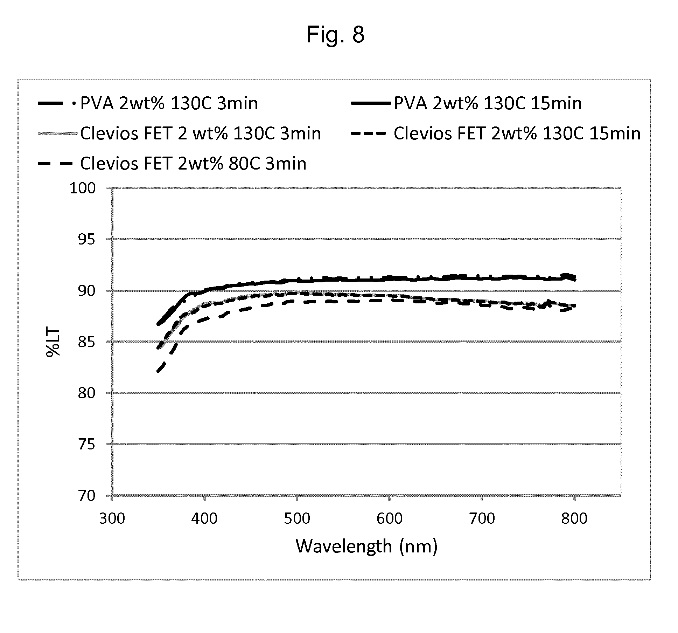

The effect of drying temperature and time was firstly studied on the individual PVA and PEDOT:PSS films. The results tabulated in Table 6 show that Clevios FET has better conductivity and higher %LT at 130 °C as compared to 80 °C. The b* value of Clevios FET is also more color neutral with drying at 130 °C. The longer drying time at this temperature did not change the electrical and optical properties of Clevios FET. For PVA film, the longer drying time at 130 °C slightly lower the b* value and slightly increase the %Abs. The light transmittance spectra of Clevios FET and PVA are shown in Figure 8. With drying at 130 °C, there is insignificant change in the spectrum for Clevios FET and PVA with increasing drying time from 3 to 15 min.

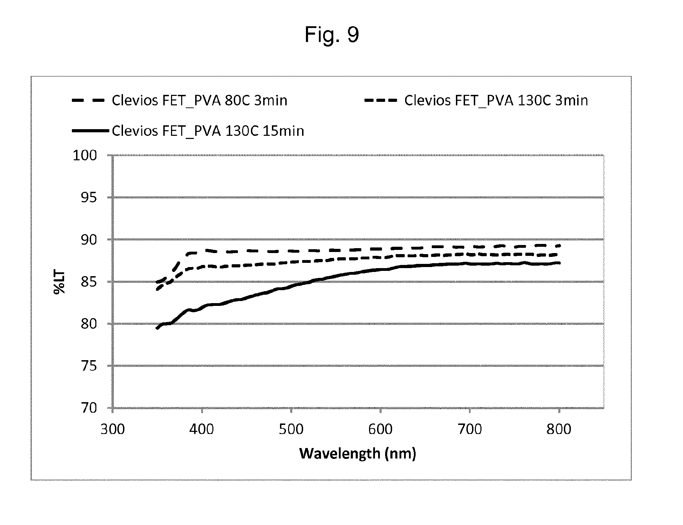

A gradual drop in %LT and increase in %Abs was observed for Clevios FET_PVA coated films with increasing drying temperature and longer drying time. These are accompanied by drastic increase in b* value and YI for the films. The light transmittance spectrum (Figure 9) shows that by increasing the drying temperature and time, there is higher absorbance in the blue-green visible light range. Visually, the Clevios FET_PVA coated film dried at 130 °C for 15 min appeared brownish in color.

**Table 6: Electrical and optical properties of Clevios FET and PVA as a function of drying time and temperature.**

| Sample | Drying parameter | | *Rs* (Ω/□) | LT (%) | R (%) | Abs (%) | Haze (%) | YI | L* | a* | b* |
|---|---|---|---|---|---|---|---|---|---|---|---|
| | Temperature (°C) | Time (min) | | | | | | | | | |
| PVA | 130 | 3 | - | 91 | 8.8 | 0.2 | 0.3 | 0.86 | 96.4 | -0.04 | 0.48 |
| | | 15 | - | 91 | 8.4 | 0.6 | 0 | 0.45 | 96.41 | -0.05 | 0.26 |
| Clevios FET | 80 | 3 | 540.8 ± 105.9 | 88.9 | 8.1 | 3.0 | 0.2 | 0.7 | 95.55 | -0.17 | 0.45 |
| | 130 | 3 | 606.6 ± 37.5 | 89.6 | 8.2 | 2.2 | 0.4 | 0.01 | 95.83 | -0.21 | 0.11 |
| | | 15 | 624.4 ± 31.1 | 89.5 | 8.3 | 2.2 | 0.4 | 0.09 | 95.81 | -0.21 | 0.15 |
| Clevios FET_PVA | 80 | 3 | 14645.2 ± 1779.5 | 88.8 | 9.3 | 1.9 | 0.3 | 0.3 | 95.47 | 0.1 | 0.1 |
| | 130 | 3 | 2986.1 ± 987.4 | 87.6 | 9.1 | 3.3 | 0.3 | 1.01 | 94.99 | 0.11 | 0.47 |
| | | 15 | 3380.8 ± 1254.0 | 85.7 | 8.9 | 5.4 | 0.1 | 3.53 | 94.11 | 0.22 | 1.75 |

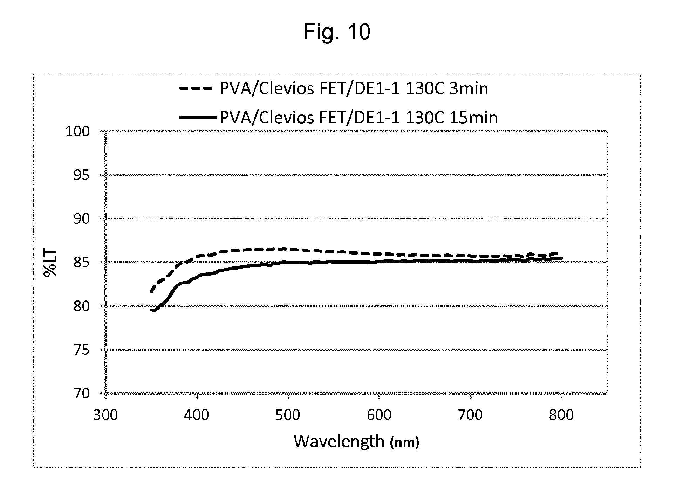

Similarly, when PVA / Clevios FET / DE1-1 film was dried at longer time at 130 °C, there is a drop in %LT and increase in %Abs, YI , and b* values as set forth in Table 7. The blue-green visible light region also has higher absorption with increasing drying time as observed from Figure 10.

**Table 7: Electrical and optical properties of PVA / Clevios FET / DE1-1 as a function of drying time.**

| Sample | Drying parameter | | Rs (Ω/Δ) | LT (%) | R(%) | Abs (%) | Haze (%) | YI | L* | a* | b* |
|---|---|---|---|---|---|---|---|---|---|---|---|
| | Temperature (°C) | Time (min) | | | | | | | | | |
| PVA / Clevios FET / DE1-1 | 130 | 3 | N.A. | 86.2 | 9.3 | 4.5 | 0.6 | -0.43 | 94.39 | -0.23 | -0.11 |
| | | 15 | N.A. | 85.0 | 9.1 | 5.9 | 0.7 | 0.69 | 93.88 | -0.11 | 0.42 |

### 4.6 Different PVA concentration studies

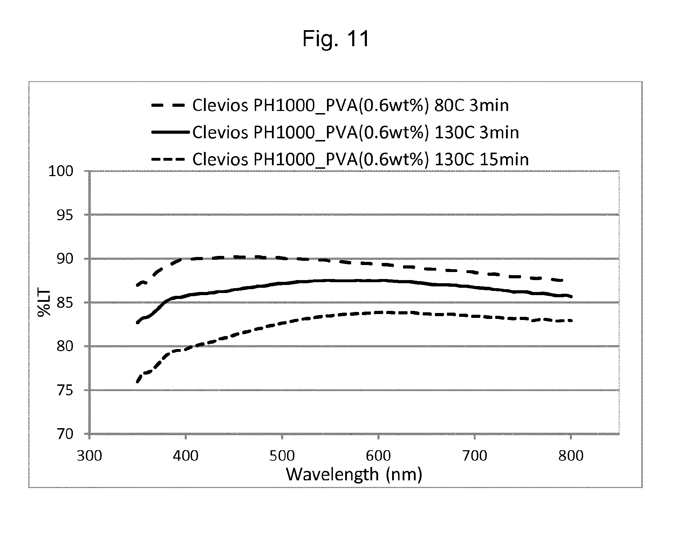

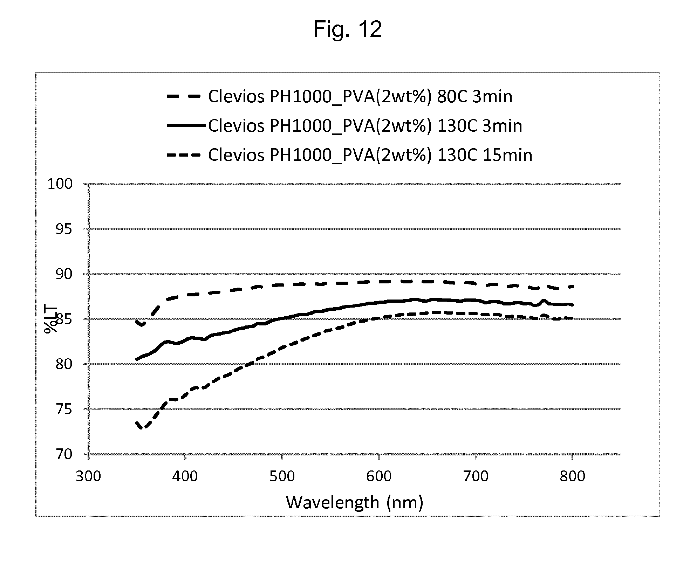

Clevios PH1000 was mixed with two different PVA concentration, namely 0.6 wt.-% and 2 wt.-% to see the effect of PVA concentration on the optical properties of PEDOT:PSS_PVA coated films. The concentration of Clevios PH1000 in the formulation was kept at 0.6wt.-%. Clevios PH1000_PVA with lower PVA concentration (0.6 wt.-%) has slightly higher %LT and lower %Abs compared to the film with higher PVA concentration (2 wt.-%) of the same drying temperature and time. A very obvious difference is observed with its b* and YI values whereby Clevios PH1000_PVA (2 wt.-%) has higher values than those of Clevios PH1000_PVA(0.6 wt.-%) of the same drying temperature and time. The absorption at blue-green visible light region is also more prominent for higher PVA concentration film as observed from the light transmittance spectra shown in Figures 11 and 12. The results of this study show that the color properties of PEDOT:PSS_PVA coated film is affected by the PVA concentration in the formulation, whereby a higher PVA concentration resulted in higher b* and YI values due to the higher absorption in the blue-green visible light region.

**Table 8: Electrical and optical properties of Clevios PH1000 and PVA as function of PVA concentration, drying time and temperature.**

| Sample | Drying parameter | | Resistance-3 cm distance (kΩ) | LT (%) | R(%) | Abs (%) | Haze (%) | YI | L* | a* | b* |
|---|---|---|---|---|---|---|---|---|---|---|---|
| | Temperature (°C) | Time (min) | | | | | | | | | |
| Clevios PH1000_PVA (0.6 wt.-%) | 80 | 3 | Non conductive | 89.7 | 8.0 | 2.3 | 0.1 | -0.87 | 95.87 | -0.27 | -0.33 |
| Clevios PH1000_PVA (0.6 wt.-%) | 130 | 3 | Non conductive | 87.4 | 8.0 | 4.6 | 0.1 | 1.03 | 94.89 | -0.21 | 0.64 |
| Clevios PH1000_PVA (0.6 wt.-%) | | 15 | Non conductive | 83.4 | 8.6 | 8.0 | 0.4 | 2.76 | 93.14 | -0.16 | 1.51 |
| Clevios PH1000_PVA (2wt.-%) | 80 | 3 | Non conductive | 88.9 | 8.3 | 2.8 | 0.1 | 0.91 | 95.54 | -0.05 | 0.5 |
| Clevios PH1000_PVA (2wt.-%) | 130 | 3 | Non conductive | 85.7 | 8.2 | 6.1 | 0.3 | 3.33 | 94.14 | 0.19 | 1.66 |
| Clevios PH1000_PVA (2wt.-%) | | 15 | Non conductive | 83.8 | 7.7 | 8.5 | 0.1 | 6.38 | 93.25 | 0.23 | 3.25 |

### 4.7 FTIR studies

To have a better understanding on the mechanism of the color change in PEDOT:PSS_PVA coated film, the coated films were subjected to ATR FTIR characterization to study the change in the molecular structure.

### 4.8 PVA

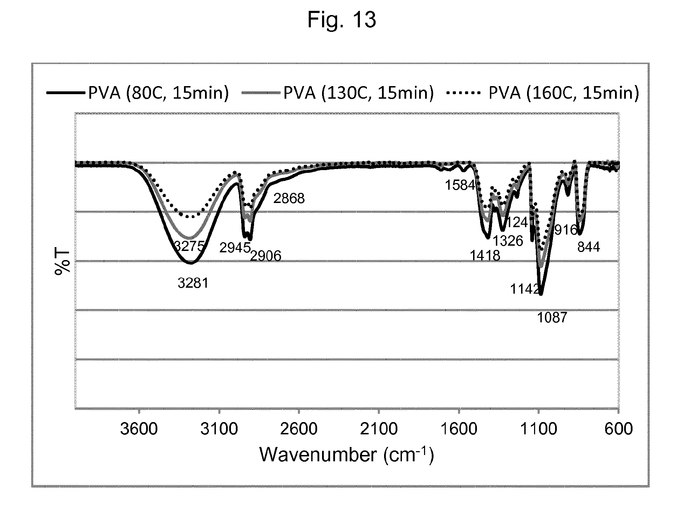

The ATR FTIR spectra of PVA dried with increasing drying temperature are shown in Figure 13. The film was firstly dried at 80 °C, followed by drying at 130 and 160 °C. The drying time was 15 min for each temperature in the oven. The assignments of the main vibrations are listed in Table 9. The vibration modes are in general decrease in intensity as the drying temperature increases. The O-H stretching vibration of the hydroxyl group at 3281 to 3275 cm⁻¹ decreases which indicates dehydration process with increasing drying temperature. Some reported studies have suggested that the result from the dehydration is formation of polyene. Though the C=C vibration is not observed from our spectra, the possibility of polyene formation is supported by the decrease vibration modes of CH₂ (stretching modes at 2945 and 2908 cm⁻¹ and its wagging modes at 1418 and 1326 cm⁻¹) and C-O (stretching modes at 1142 and 1087) cm⁻¹.

**Table 9: Assignments of the main vibrations of PVA FTIR spectra.**

| Wavenumber (cm⁻¹) | IR band assignment |
|---|---|
| 3281 to 3275 | O-H stretching vibration of hydroxyl group |
| 2945 and 2908 | CH₂ assymetric stretching |
| 2868 | CH₂ symmetric stretching |
| 1665 to 1568 | C-O-H bending |
| 1418 and 1326 | Wagging of CH₂ vibration |
| 1142 and 1087 | C-O stretching |

### 4.9 PEDOT:PSS (Clevios PH1000)

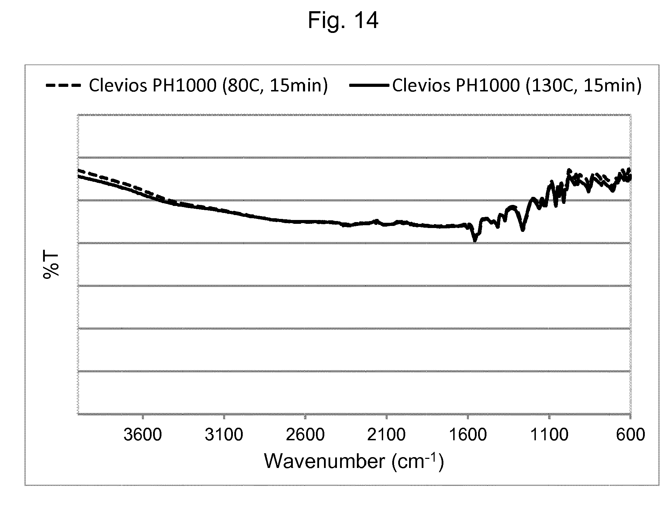

The ATR FTIR of PEDOT:PSS (Clevios PH1000) spectra are shown in Figure 14. The vibration modes from 1600 to 1336 cm⁻¹ can be assigned to C-C and C=C stretching mode in the thiophene ring. The vibration modes between 1260 and 1000 cm⁻¹ originated from the C-O-C stretching mode. Stretching mode from the C-S bond in the thiophene ring can be seen at 863, 738, and 697 cm⁻¹. It is observed that there is no change in the PEDOT:PSS spectra as drying temperature is increased from 80 to 130 °C.

### 4.10 Clevios PH1000_PVA

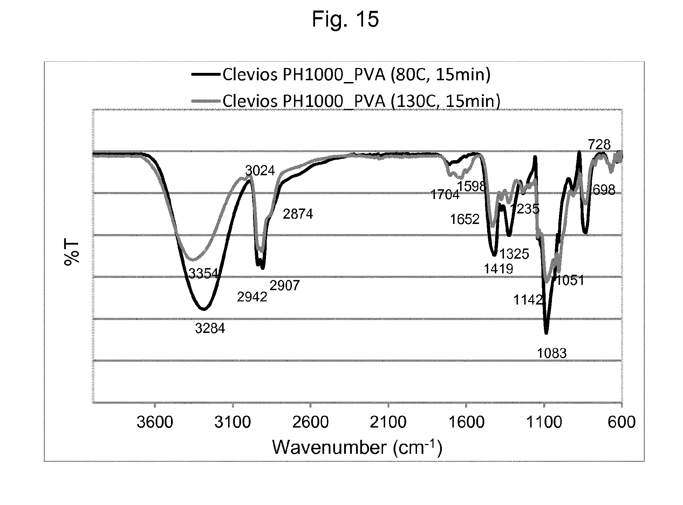

Figure 15 shows the ATR FTIR of Clevios PH1000_PVA with PVA concentration of 0.6 wt.-%. The increase in drying temperature causes the decrease in O-H stretching vibration at 3354 to 3284 cm⁻¹ from PVA showing the elimination of H₂O process. The presence of C=C due to the polyene formation as a product of the H₂O elimination was affirmed by the appearance of peaks at 1652 and 1598 cm⁻¹ which represent vibration mode of C=C and a peak at 3021 cm⁻¹ which represents olefinic C-H stretch with further heating at 130 °C for 15 min. It has been reported that conjugated and non-conjugated polyenes are formed during the dehydration of PVA. The decrease vibration modes of CH₂ (stretching modes at 2942 and 2907 cm⁻¹ and its wagging modes at 1419 and 1325 cm⁻¹) and C-O (stretching modes at 1142 and 1083 cm⁻¹) were also observed. Stretching mode of C=O at 1704 cm⁻¹ showing the presence of carbonyl after drying at 130 °C may indicate the inclusion of atmospheric oxygen in the polymer as the film was dried in air ambience.

**Table 10: Assignments of the main vibrations of PEDOT:PSS_PVA FTIR spectra.**

| Wavenumber (cm⁻¹) | IR band assignment |
|---|---|
| 3354 - 3284 | O-H stretching vibration of hydroxyl group |
| 3024 | Olefinic C-H stretch |
| 2942 and 2907 | CH₂ assymetric stretching |
| 2865 | CH₂ symmetric stretching |
| 1704 | C=O stretching mode (ketone) |
| 1652, 1598 | C=C (alkene) |
| 1419 and 1325 | Wagging of CH₂ vibration |
| 1235 | CH₂OH (side chain related mode) |
| 1142 and 1083 | C-O stretching |
| 728 and 698 | C-S stretch in thiophene ring |

### 4.11 XPS studies

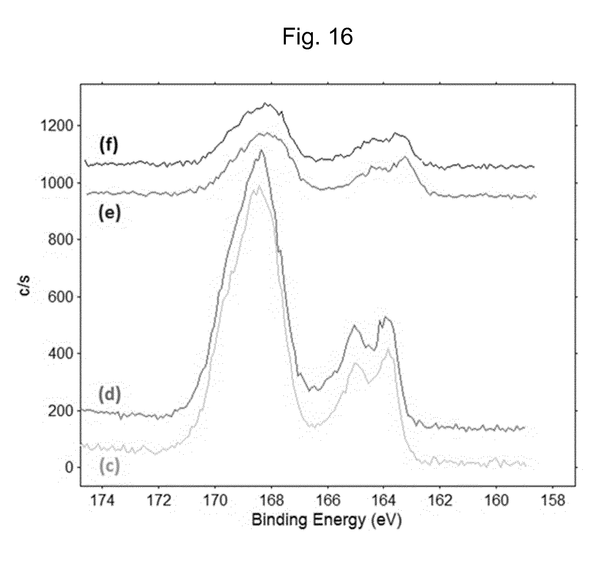

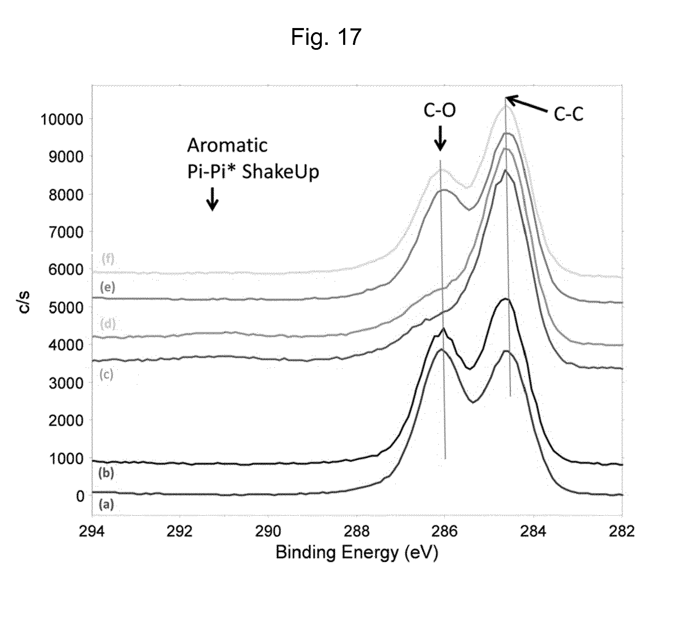

PVA, PEDOT:PSS (Clevios PH1000), and PEDOT:PSS (Clevios PH1000)_PVA coated films were then subjected for XPS studies. The films were subjected to drying at 80 or 130 °C for 15 min, respectively. Spectra from S2p and C1s are of the main interest. The high resolution spectra of S2p, which is shown in Figure 16, are to indicate the PEDOT:PSS content on the surface. XPS bands with binding energy between 166 and 172 eV correspond to the sulfur atoms in PSS, while two XPS bands with binding energy between 162 and 166 eV correspond to the sulfur atoms in PEDOT. The results of the S2p deconvolution tabulated in Table 10 shown that the pristine PEDOT:PSS in Clevios PH1000 have a ratio of 1:3. There is no change in the ratio with increasing drying temperature showing that there is no degradation of the PEDOT:PSS film. However, when PEDOT:PSS is mixed with PVA, it is shown that the ratio of PEDOT:PSS became 1:2 which may indicate that there are more PEDOT being exposed to the surface for this film. The high resolution C1s spectra shown in Figure 17 could give information of C-C and C-O bonds present in the system. C-C bond has a binding energy of 285 eV and C-O bond has a binding energy of 286.5 eV. As shown in Table 10, for pristine PEDOT:PSS film, there are no changes in the intensity of C-C and C-O bond with increasing drying temperature, thus there is no change in the C-O/C-C ratio. Interestingly, there is a drop in the C-O/C-C ratio for PVA and PEDOT:PSS_PVA if the films were dried at higher temperature. The change in the ratio is suggested to be contributed by the change in PVA molecular structure as PEDOT:PSS results have shown that there are no changes in the intensity of C-C and C-O with increasing drying temperature. This decrease in C-O bond intensity for PVA is also observed in the FTIR spectra discussed in the previous section. Thus, it reaffirms our observation that H₂O elimination from PVA has taken place, yielding in the formation of polyene structure. Unfortunately, the C-C and C=C could not be distinguished by XPS spectra.

**Table 11: Deconvolution of S2p and C1s peaks of PVA, Clevios PH1000, and Clevios PH1000_PVA coated films.**

| Sample code | Film | S₂ₚ₃ 163,8 eV | S₂ₚ₃ 168,4 eV | | C₁ₛ 285,0 eV | C₁ₛ 286,5 eV | Ratio of C-O/C-C |
|---|---|---|---|---|---|---|---|
| | | PEDOT | PSS | | C-C | C-O- | |
| a | PVA; dried at 80 °C, 15 min | - | - | | 31.7 | 35.3 | 1.11 |
| b | PVA; dried at 130 °C, 15 min | - | - | | 37.2 | 32.1 | 0.86 |
| | | | | | | | |
| c | Clevios PH1000; dried at 80 °C, 15 min | 2.0 | 6.0 | | 48.0 | 11.3 | 0.24 |
| d | Clevios PH1000; dried at 130 °C, 15 min | 2.1 | 6.0 | | 47.5 | 11.2 | 0.24 |
| | | | | | | | |
| e | Clevios PH1000_PVA; dried at 80 °C, 15 min | 0.7 | 1.4 | | 40.5 | 28.6 | 0.71 |
| f | Clevios PH1000_PVA; dried at 130 °C, 15 min | 0.7 | 1.4 | | 41.4 | 26.9 | 0.65 |

It was demonstrated by the above that the interaction of PEDOT:PSS with PVA in the coated films causes the film to have lower %LT due to higher %Abs and more importantly, a color change from bluish to a more color neutral tone. This color change is dependent on the PVA concentration, drying temperature and time. There has been report on thermally degraded PVA whereby elimination of H₂O is a prevalent mechanism with thermal treatment up to ∼250 °C, resulting in the dehydration of PVA and formation of polyene structure. Polyene is a poly-unsaturated organic containing conjugated carbon-carbon bonds. The conjugated bonds could lower the absorption energy state of polyene from UV to visible region. With increasing amount of polyene sections, as the drying temperature increases and drying time prolonged, PVA could have further color changes to brown to black, depending upon the degree of dehydration.

In the PEDOT:PSS_PVA formulation according to the present invention, it is also important to note that the system is in acidic state. Table 11 shows the pH of the formulations that are used for the above studies. It is suggested that the acidic state of the PEDOT:PSS_PVA formulation due to the presence of PSSH, catalyzed the dehydration of PVA to happen at lower temperature and accelerated the polyene formation. This argument is supported by the FTIR spectra (Figure 15) whereby C=C stretching mode was observed for PEDOT:PSS_PVA dried at 130 °C, but was not seen in PVA film dried at the same temperature (Figure 13).

Thus, it is concluded that by adding polymer additive (preferably having a molecular weight of from 10,000 to 200,000) having hydroxy functional groups and able to form polyene structure with heat treatment, such as PVA, it is possible to tailor the color values of PEDOT:PSS film by controlling the additive concentration, heating temperature and time.

**Table 12: pH of the formulations.**

| Formulation | pH |
|---|---|
| Clevios PH1000 0.6wt% | 2.17 |
| PVA 2wt% | 6.94 |
| Clevios PH1000 (0.6wt%)_PVA (0.6wt%) | 2.29 |
| Clevios FET (2wt%)_PVA (2wt%) | 2.35 |
| Clevios FET, control 0.168wt% | 2.06 |
| Clevios FET_PVA 0.168wt% | 2.15 |

## Claims

1. Aqueous composition, comprising (a) a conducting polymer selected from the group consisting of polyanilines, polypyroles, polythiophenes and polyphenylenes, (b) a polyacid and (c) a polymeric additive having hydroxyl functional groups, wherein the pH-value of the aqueous composition is ≤ 3.5.

2. Composition according to claim 1, wherein (a) the conducting polymer or a combination of (a) the conducting polymer and (b) the polyacid absorb light having wavelengths in the range of from 580 nm to 700 nm, such that (a) or the combination of (a) and (b) have a blue color,
wherein the composition comprising (a), (b) and (c) is colorless or substantially colorless.

3. Composition according to claims 1 or 2, wherein the conducting polymer (a) is a polythiophene and the polyacid (b) is a polysulfonic acid.

4. Composition according to at least one of the preceding claims, wherein the conducting polymer (a) is poly(3,4-ethylenedioxythiophene) and the polyacid (b) is poly(styrensulfonic acid).

5. Composition according to at least one of the preceding claims, wherein the polymeric additive (c) is poly(vinyl)alcohol having a molecular weight in the range of from ≥ 10,000 to ≤ 200,000.

6. Composition according to at least one of the preceding claims, wherein the polymeric additive (c) is contained in an amount of at least 0.05 wt.-%, based on the total weight of the composition.

7. Composition according to at least one of the preceding claims, wherein the polymeric additive (c) is contained in an amount in the range of from ≥ 0.1 to ≤ 10 wt.-%, preferably in the range of from ≥ 0.12 to ≤ 8 wt.-%, more preferably in the range of from ≥ 0.14 to ≤ 5 wt.-%.

8. Film, comprising a conducting polymer (a) selected from the group consisting of polyanilines, polypyroles, polythiophenes and polyphenylenes, a polyacid (b) and a polymeric additive (c) comprising polyene structures obtained from hydroxyl functional groups.

9. Film according to claim 8, wherein the conducting polymer (a) is a polythiophene and the polyacid (b) is a polysulfonic acid.

10. Film according to claim 8 or 9, wherein the conducting polymer (a) is poly(3,4-ethylenedioxythiophene), the polyacid (b) is poly(styrensulfonic acid) and the polymeric additive (c) is poly(vinyl)alcohol.

11. Process for producing a conducting film on a substrate, the process comprising the following steps:
(i) coating a substrate with a composition according to at least one of claims 1 to 7,
(ii) heating the film.

12. Process according to claim 11, wherein the heating is conducted at a temperature in the range of from ≥ 50 °C to ≤ 200 °C, preferably in the range of from ≥ 70 °C to ≤ 170 °C, more preferably in the range of from ≥ 80 °C to ≤ 150 °C.

13. Process according to claim 11 or 12, wherein the heating is conducted over a period of time in the range of from ≥ 2 minutes to ≤ 20 minutes, preferably in the range of from ≥ 3 minutes to ≤ 18 minutes, more preferably in the range of from ≥ 5 minutes to ≤ 16 minutes.

14. Process according to at least one of claims 11 to 13, wherein the substrate is coated in step (i) with a coating having a wet thickness in the range of from ≥ 5 µm to ≤ 40 µm, preferably in the range of from ≥ 10 µm to ≤ 30 µm, more preferably in the range of from > 15 µm to ≤25 µm.

15. Use of the film according to at least one of claims 1 to 7 or the film according to at least one of claims 8 to 10 for the production of transparent conductive films.
